# FASCICULE DE BREVET EUROPEEN

(11) **EP 3 450 277 B1**
(45) Date de publication et mention de la délivrance du brevet: **17.03.2021**
(21) Numéro de dépôt: 18191661.0
(22) Date de dépôt: 30.08.2018
(51) Int. Cl.: B61C 3/00, B61C 17/04, B61D 27/00

(54) **MOTRICE DE TRAIN À GRANDE VITESSE AVEC SURPRESSION INTERNE**
TRIEBWAGEN FÜR HOCHGESCHWINDIGKEITSZUG MIT INNEREM ÜBERDRUCK
HIGH-SPEED TRAIN POWER CAR WITH INTERNAL OVERPRESSURE

(30) Priorité: 30.08.2017 FR 1758004
(43) Date de publication de la demande: 06.03.2019
(73) Titulaire: SpeedInnov, 75008 Paris (FR)
(72) Inventeur: PREISS, Paul, 67110 Reichshoffen (FR); DEBOST, Pierre, 92230 Genevilliers (FR); GRAPPEIN, Etienne, 68700 Uffholtz (FR); FAVERGER, Marion, 90000 Belfort (FR)
(74) Mandataire: Lavoix

(56) Documents cités:
- EP-A- 0 233 577
- EP-A1- 0 625 456
- WO-A1-2012/060139
- FR-A1- 2 703 967
- JP-A- 2009 234 310

## Description

La présente invention concerne une motrice de train à grande vitesse, du type comportant une caisse et au moins un moteur de traction de ladite caisse ; ladite caisse comportant une toiture et un plancher ; l'au moins un moteur de traction étant disposé sous ledit plancher ; la caisse comportant en outre un local technique défini entre ladite toiture et ledit plancher, ledit local technique comprenant : des équipements électriques de commande de l'au moins un moteur de traction ; et au moins un premier dispositif de ventilation desdits équipements électriques.

L'invention s'applique particulièrement au transport de voyageurs. Un train à grande vitesse comprend une ou plusieurs motrices, le plus souvent une à chaque extrémité de rame, et un certain nombre de voitures passagers.

Dans les trains à grande vitesse actuels, la ventilation des équipements électriques des motrices est assurée par des orifices d'aération ménagés dans des parois latérales desdites motrices. Le déplacement de la rame génère un flux d'air qui refroidit lesdits équipements électriques. Cependant, un tel système de ventilation expose les équipements électriques aux poussières extérieures, à l'humidité, voire à la neige.

Il est par ailleurs connu, notamment du document US2013/0252527, d'équiper des motrices ferroviaires de ventilateurs électriques. Les systèmes connus imposent toutefois des contraintes sur l'architecture de la motrice

Le document EP 0 625 456 A1 se rapporte à un dispositif de ventilation dans un véhicule ferroviaire. Ce document décrit une motrice de train à grande vitesse, notamment pour le transport de voyageurs, ladite motrice comprenant une caisse et au moins un moteur de traction de ladite caisse. La caisse comporte une toiture et un plancher; le moteur de traction étant disposé sous ledit plancher. La caisse comporte en outre un local technique défini entre ladite toiture et ledit plancher; le local technique comprend: des équipements électriques de commande de l'au moins un moteur de traction; et un dispositif de ventilation desdits équipements électriques. Le dispositif de ventilation comporte: une gaine d'arrivée d'air, formant un conduit fermé entre une entrée et une sortie; et un ventilateur disposé entre l'entrée et la sortie de ladite gaine.

Le document WO 2012/060139 A1 se rapporte à un dispositif de refroidissement dans un véhicule ferroviaire. Ce document décrit une motrice de train comprenant une caisse et au moins un moteur de traction de ladite caisse. La caisse comporte une toiture et un plancher. La caisse comporte en outre un local technique défini entre ladite toiture et ledit plancher; le local technique comprend: des équipements électriques; et un dispositif de ventilation desdits équipements électriques. Le dispositif de ventilation comporte: une gaine d'arrivée d'air, formant un conduit fermé entre une entrée et une sortie; et un ventilateur disposé entre l'entrée et la sortie de ladite gaine.

La présente invention a pour but d'améliorer les dispositifs existants, en fournissant un système de ventilation des équipements électriques, tout en optimisant la qualité de l'air intérieur et en permettant d'améliorer le design de la motrice.

A cet effet, l'invention a pour objet une motrice de train à grande vitesse du type précité, dans laquelle le premier dispositif de ventilation comporte : une première gaine d'arrivée d'air, formant un conduit fermé entre une entrée et une sortie ouverte sur le local technique ; et un premier ventilateur disposé entre l'entrée et la sortie de ladite première gaine, de sorte à créer une surpression dans le local technique.

Suivant d'autres aspects avantageux de l'invention, la motrice comporte l'une ou plusieurs des caractéristiques suivantes, prises isolément ou suivant toutes les combinaisons techniquement possibles :
- l'entrée de la première gaine est disposée au niveau d'une première bouche d'entrée d'air située en toiture de la caisse, et le premier dispositif de ventilation comporte un premier organe de filtration disposé en entrée de la première gaine, ledit premier organe de filtration étant perméable à l'air et apte à retenir des particules solides de dimensions supérieures à un premier seuil ;
- le premier organe de filtration comporte des éléments déflecteurs de type persiennes ;
- les éléments déflecteurs définissent des canaux d'entrée d'air disposés selon une direction perpendiculaire à une direction principale de déplacement de la motrice ;
- le premier dispositif de ventilation comporte un deuxième organe de filtration, disposé dans la première gaine entre le premier organe de filtration et le premier ventilateur, ledit deuxième organe de filtration étant perméable à l'air et apte à retenir des particules solides de dimensions supérieures à un deuxième seuil, ledit deuxième seuil étant inférieur au premier seuil ;
- le deuxième organe de filtration comporte un panneau de matériau textile ;
- le premier dispositif de ventilation comporte en outre au moins une bouche de sortie d'air, située en toiture de la caisse et en communication fluidique avec le local technique ;
- la caisse comporte en outre au moins un deuxième dispositif de ventilation distinct du premier dispositif de ventilation, ledit deuxième dispositif de ventilation comportant : une deuxième gaine d'arrivée d'air, formant un conduit fermé entre une entrée et une sortie ouverte sur le local technique ; et un deuxième ventilateur disposé entre l'entrée et la sortie de ladite gaine, les première et deuxième gaines étant situées proches d'extrémités opposées de la caisse.

L'invention sera mieux comprise à la lecture de la description qui va suivre, donnée uniquement à titre d'exemple non limitatif et faite en se référant aux dessins sur lesquels :
- la figure 1 est une vue en coupe longitudinale partielle d'une motrice selon un mode de réalisation de l'invention ; et
- la figure 2 est une vue en coupe transversale de la motrice de la figure 1, les parties gauche et droite représentant respectivement l'avant et l'arrière du local technique.

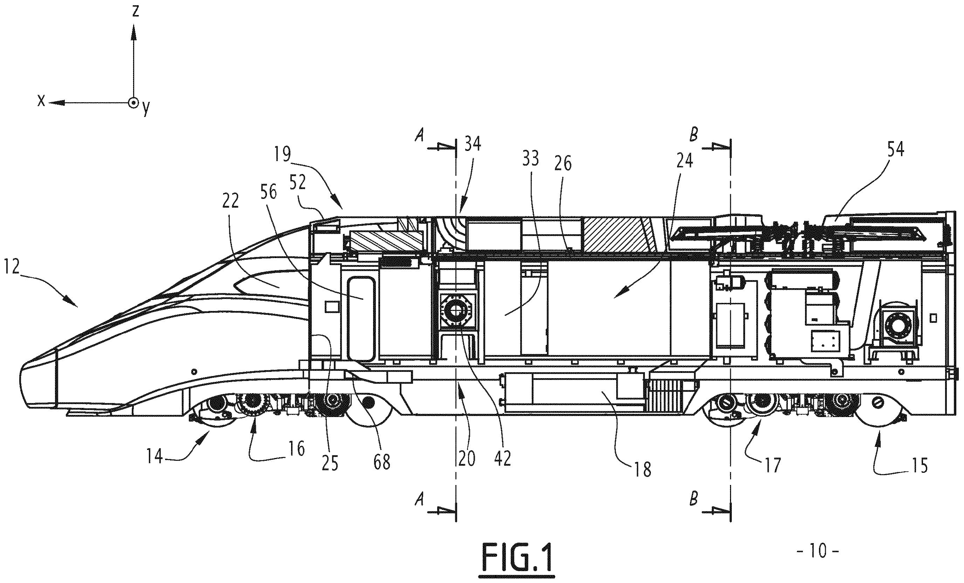

La figure 1 représente une motrice 10 de train à grande vitesse, selon un mode de réalisation de l'invention. La motrice 10 est destinée à être assemblée à des véhicules ferroviaires de type wagons de transports de voyageurs, pour former un train.

La motrice 10 comprend une caisse 12, ainsi que deux bogies 14, 15 et deux moteurs de traction 16, 17, disposés sous ladite caisse 12. Chaque moteur de traction 16, 17 est destiné à mettre en mouvement les roues de l'un des bogies 14, 15. La motrice 10 comprend en outre un transformateur électrique 18, relié aux moteurs de traction 16, 17 et également disposé sous la caisse 12.

La caisse 12 comporte une toiture 19 et un plancher 20, qui délimitent verticalement ladite caisse. Les bogies 14, 15 et les moteurs de traction 16, 17 sont disposés sous le plancher 20. La caisse 12 comporte en outre des parois latérales 21.

La caisse 12 présente une forme allongée. On considère une base orthonormée (X, Y, Z), la direction Z représentant la verticale. La caisse 12 s'étend principalement selon la direction X, correspondant à une direction de déplacement habituelle de la motrice 10. La caisse 12 comporte une extrémité avant, formée par une cabine de conduite 22.

Un premier bogie 14 et un premier moteur de traction 16 sont situés proches de ladite extrémité avant de la caisse 12. Un deuxième bogie 15 et un deuxième moteur de traction 17 sont situés proches d'une extrémité arrière, opposée, de la caisse 12.

Adjacent à la cabine de conduite 22 selon X, la caisse 12 comporte un compartiment technique 24, également appelé local technique. Ledit compartiment technique est séparé de la cabine de conduite 22 par une cloison 25. Le compartiment technique 24 est représenté en coupe sur la figure 1.

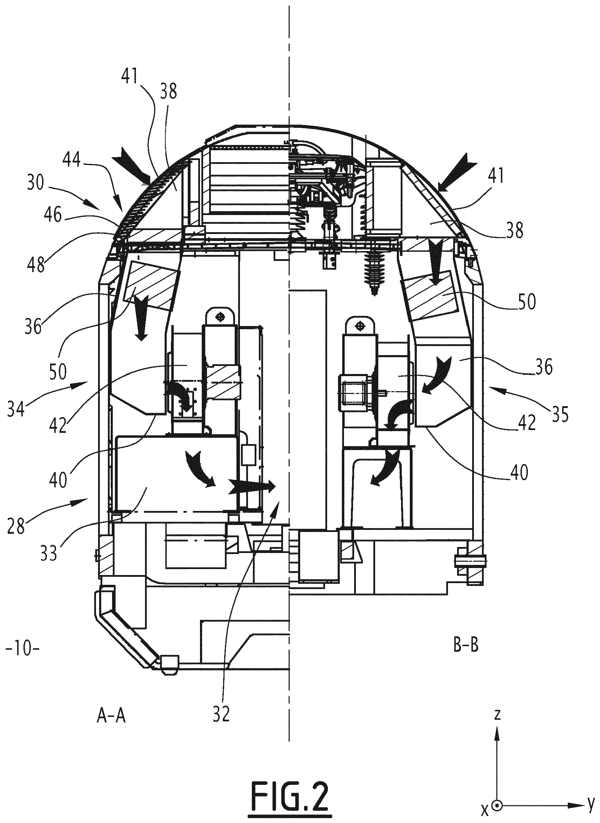

La partie gauche de la figure 2 montre une vue en coupe transversale de la caisse 12, au niveau de l'avant dudit compartiment technique 24, selon un plan de coupe A-A indiqué sur la figure 1. La partie droite de la figure 2 montre une vue en coupe transversale de la caisse 12, au niveau de l'arrière dudit compartiment technique 24, selon un plan de coupe B-B indiqué sur la figure 1.

Dans un plan (X, Z), le compartiment technique 24 est délimité par la toiture 19, le plancher 20 et les parois latérales 21. Le compartiment technique 24 comporte un plafond 26, qui le divise selon Z entre un étage inférieur 28 et un étage supérieur 30. Le plafond 26 marque notamment une limite selon Z entre les parois latérales 21 et la toiture 19, lesdites parois latérales 21 étant sensiblement planes et verticales et ladite toiture 19 ayant une forme bombée.

L'étage inférieur 28 du compartiment technique 24 comporte un couloir central 32 et une pluralité d'équipements techniques, installés de part et d'autre dudit couloir central à proximité des parois latérales 21. Lesdits équipements techniques seront décrits ci-après.

Avantageusement, le couloir central 32 a une largeur selon Y comprise entre 500 mm et 750 mm, de préférence égale à 750 mm environ. Cette largeur est déterminée pour permettre un passage confortable d'un opérateur, sans limiter sensiblement le volume disponible pour les équipements de la motrice.

L'étage inférieur 28 du compartiment technique 24 comporte au moins un coffre de traction 33. Ledit coffre de traction 33 comprend des équipements électriques et/ou électroniques de commande des moteurs de traction 16, 17.

L'étage inférieur 28 du compartiment technique 24 comporte au moins un premier dispositif de ventilation 34. Ledit premier dispositif de ventilation 34 permet d'insuffler de l'air frais à l'intérieur dudit étage inférieur 28, afin notamment de refroidir les équipements électriques et/ou électroniques de l'au moins un coffre de traction 33.

Le premier dispositif de ventilation 34est disposé sensiblement à l'avant du compartiment technique 24, à proximité du premier bogie 14. De préférence, l'étage inférieur 28 comporte en outre un deuxième dispositif de ventilation 35 similaire, disposé sensiblement à l'arrière du compartiment technique 24 à proximité du deuxième bogie 15 et du deuxième moteur de traction 17. Les premier 34 et deuxième 35 dispositifs de ventilation sont visibles sur la figure 2. La description ci-après s'applique également au premier 34 et au deuxième 35 dispositif de ventilation, les éléments communs auxdits dispositifs étant désignés par les mêmes numéros de référence.

Le dispositif de ventilation 34, 35 comporte une gaine d'arrivée d'air 36. Ladite gaine 36 forme un conduit fermé, à l'exception d'une entrée 38 et d'une sortie 40.

L'entrée 38 de la gaine est disposée au niveau de la toiture 19 de la caisse 12. Plus précisément, l'entrée 38 est formée par une première bouche 41 d'entrée d'air, incorporée à la toiture 19.

A partir de l'entrée 38, la gaine 36 s'étend dans l'étage supérieur 30 du compartiment technique 24, traverse le plafond 26 et se poursuit jusqu'à la sortie 40, disposée dans l'étage inférieur 28.

Le dispositif de ventilation 34, 35 comporte en outre un ventilateur 42 électrique, situé dans l'étage inférieur 28 au niveau de la sortie 40. Le ventilateur 42 est apte à insuffler de l'air extérieur à la caisse 12 dans l'étage inférieur 28, de sorte à créer une légère surpression à l'intérieur dudit étage inférieur.

Le dispositif de ventilation 34, 35 comporte en outre un premier organe de filtration 44, disposé en entrée 38 de la gaine 36. Le premier organe de filtration 44 est perméable à l'air et apte à retenir des particules solides de dimensions supérieures à un premier seuil. A titre indicatif, ledit premier seuil est compris entre 80 micromètres et 120 micromètres ; typiquement ledit premier seuil est de 90 micromètres.

De préférence, le premier organe de filtration 44 comporte des éléments déflecteurs mécaniques, tels que des persiennes 46. Lesdites persiennes 46 définissent des canaux 48 qui forment l'entrée 38 de la gaine 36. De préférence, lesdits canaux 48 sont disposés selon la direction transversale Y, soit perpendiculairement à la direction principale X de déplacement de la motrice 10.

Les persiennes 46 permettent ainsi de limiter la pénétration de gouttes d'eau et de particules de poussière dans l'entrée 38 de la gaine 36, au cours du déplacement de la motrice 10.

Le dispositif de ventilation 34, 35 comporte en outre un deuxième organe de filtration 50. Ledit deuxième organe de filtration est disposé dans la gaine 36, entre le premier organe de filtration 44 et le ventilateur 42. Le deuxième organe de filtration 50 est perméable à l'air et apte à retenir des particules solides de dimensions supérieures à un deuxième seuil, ledit deuxième seuil étant inférieur au premier seuil. A titre indicatif, ledit deuxième seuil est compris entre 50 micromètres et 80 micromètres.

De préférence, le deuxième organe de filtration 50 comporte un panneau de matériau textile, ou d'un autre matériau perméable à l'air, disposé en travers de la gaine 36. Le deuxième organe de filtration 50 est destiné à prévenir de manière optimale la pénétration de poussières dans l'étage inférieur 28 du compartiment technique 24.

Le dispositif de ventilation 34, 35 comporte en outre au moins une bouche de sortie d'air 52, 54, située en toiture 19 de la caisse 12 et en communication fluidique avec l'étage inférieur 28 du compartiment technique 24. La surpression générée par le ventilateur 42 dans le compartiment technique 24, par rapport à l'extérieur de la caisse 12, empêche la pénétration de poussières par ladite bouche de sortie d'air 52, 54. En variante, la bouche de sortie d'air 52, 54 n'est pas munie de filtre.

Dans le mode de réalisation représenté à la figure 1, la caisse 12 comporte une première 52 et une deuxième 54 bouches de sortie d'air, respectivement situées à l'avant et à l'arrière de la toiture 19.

L'aspiration de l'air en toiture 19 au lieu d'une aspiration sur les parois latérales 21 permet notamment de réduire le bruit vis-à-vis de l'extérieur.

Le compartiment technique 24 comporte au moins une ouverture ménagée dans une paroi latérale 21 et obturée de manière réversible par une porte 56. Ladite porte 56 donne accès de l'extérieur au couloir central 32 de l'étage inférieur 28. De préférence, les parois latérales 21 ne comportent aucune ouverture dégagée de manière permanente. Outre la limitation de la pollution du compartiment technique 24, de telles parois latérales sans ouverture sont plus esthétiques et permettent plus de liberté en matière de design.

Avec les deux dispositifs de ventilation 34 et 35, il est possible de faire fonctionner les ventilateurs 42 à vitesse réduite afin de créer une légère surpression dans le compartiment technique 24, comme décrit ci-dessus.

Par ailleurs, lorsque les équipements techniques du compartiment technique 24 échauffent l'atmosphère interne dudit compartiment technique, les ventilateurs 42 sont mis en fonctionnement à pleine vitesse afin d'évacuer les calories vers l'extérieur.

## Revendications

1. Motrice (10) de train à grande vitesse, notamment pour le transport de voyageurs, ladite motrice comprenant une caisse (12) et au moins un moteur de traction (16, 17) de ladite caisse,
ladite caisse comportant une toiture (19) et un plancher (20) ; l'au moins un moteur de traction étant disposé sous ledit plancher,
la caisse comportant en outre un local technique (24) défini entre ladite toiture et ledit plancher,
ledit local technique comprenant : des équipements électriques (33) de commande de l'au moins un moteur de traction ; et au moins un premier dispositif de ventilation (34) desdits équipements électriques,
la motrice étant **caractérisée en ce que** le premier dispositif de ventilation comporte : une première gaine (36) d'arrivée d'air, formant un conduit fermé entre une entrée (38) et une sortie (40) ouverte sur le local technique ; et un premier ventilateur (42) disposé entre l'entrée et la sortie de ladite première gaine, de sorte à créer une surpression dans le local technique.

2. Motrice de train à grande vitesse selon la revendication 1, dans laquelle :
- l'entrée (38) de la première gaine est disposée au niveau d'une première bouche d'entrée d'air (41) située en toiture (19) de la caisse, et
- le premier dispositif de ventilation (34) comporte un premier organe de filtration (44) disposé en entrée de la première gaine (36), ledit premier organe de filtration (44) étant perméable à l'air et apte à retenir des particules solides de dimensions supérieures à un premier seuil.

3. Motrice de train à grande vitesse selon la revendication 2, dans laquelle le premier organe de filtration (44) comporte des éléments déflecteurs (46) de type persiennes (46).

4. Motrice de train à grande vitesse selon la revendication 3, dans laquelle les éléments déflecteurs définissent des canaux d'entrée d'air (48) disposés selon une direction (Y) perpendiculaire à une direction principale (X) de déplacement de la motrice.

5. Motrice de train à grande vitesse selon l'une des revendications précédentes, dans laquelle le premier dispositif de ventilation (34) comporte un deuxième organe de filtration (50), disposé dans la première gaine (36) entre le premier organe de filtration (44) et le premier ventilateur (42) , ledit deuxième organe de filtration (50) étant perméable à l'air et apte à retenir des particules solides de dimensions supérieures à un deuxième seuil, ledit deuxième seuil étant inférieur au premier seuil.

6. Motrice de train à grande vitesse selon la revendication 5, dans laquelle le deuxième organe de filtration (50) comporte un panneau de matériau textile.

7. Motrice de train à grande vitesse selon l'une des revendications précédentes, dans laquelle le premier dispositif de ventilation (34) comporte en outre au moins une bouche de sortie d'air (52, 54), située en toiture de la caisse et en communication fluidique avec le local technique.

8. Motrice de train à grande vitesse selon l'une des revendications précédentes, dans laquelle la caisse comporte en outre au moins un deuxième dispositif de ventilation (35) distinct du premier dispositif de ventilation (34), ledit deuxième dispositif de ventilation comportant : une deuxième gaine (36) d'arrivée d'air, formant un conduit fermé entre une entrée et une sortie ouverte sur le local technique ; et un deuxième ventilateur (42) disposé entre l'entrée et la sortie de ladite gaine, les première et deuxième gaines étant situées proches d'extrémités opposées de la caisse (12).

## Patentansprüche

1. Triebwagen (10) für einen Hochgeschwindigkeitszug, insbesondere für den Transport von Reisenden, wobei der besagte Triebwagen aufweist eine Karosserie (12) und zumindest einen Traktionsmotor (16, 17) der besagten Karosserie,
wobei die besagte Karosserie ein Dach (19) und einen Boden (20) aufweist, wobei der zumindest eine Traktionsmotor unter dem besagten Boden angeordnet ist,
wobei die Karosserie ferner einen Technikraum (24) aufweist, welcher zwischen dem besagten Dach und dem besagten Boden definiert ist,
wobei der besagte Technikraum aufweist: elektrische Ausrüstungen (33) zum Steuern des zumindest einen Traktionsmotors und zumindest eine erste Vorrichtung zum Belüften (34) der besagten elektrischen Ausrüstungen (33),
wobei der Triebwagen **dadurch gekennzeichnet ist, dass** die erste Vorrichtung zum Belüften aufweist: einen ersten Schacht (36) zur Zufuhr von Luft, welcher eine geschlossene Leitung zwischen einem Eingang (38) und einem Ausgang (40), welcher am Technikraum offen ist, bildet, und einen ersten Lüfter (42), welcher zwischen dem Eingang und dem Ausgang des besagten ersten Schachts angeordnet ist, um einen Überdruck im Technikraum zu erzeugen.

2. Triebwagen für einen Hochgeschwindigkeitszug gemäß Anspruch 1, wobei:
- der Eingang (38) des ersten Schachts auf dem Niveau einer ersten Mündung zur Zufuhr von Luft (41) angeordnet ist, welche am Dach (19) der Karosserie angeordnet ist, und
- die erste Vorrichtung zum Belüften (34) aufweist ein erstes Organ zum Filtern (44), welches am Eingang des ersten Schachts (36) angeordnet ist, wobei das besagte erste Organ zum Filtern (44) durchlässig für Luft ist und imstande ist, feste Partikel mit Abmessungen, welche größer als ein erster Schwellwert sind, zurückzuhalten.

3. Triebwagen für einen Hochgeschwindigkeitszug gemäß Anspruch 2, wobei das erste Organ zum Filtern (44) Ablenkelemente (46) vom Lüftungsschlitze-Typ (46) aufweist.

4. Triebwagen für einen Hochgeschwindigkeitszug gemäß Anspruch 3, wobei die Ablenkelemente Kanäle zur Zufuhr von Luft (48) definieren, welche entlang einer Richtung (Y) angeordnet sind, welche senkrecht zu einer Hauptrichtung (X) der Bewegung des Triebwagens sind.

5. Triebwagen für einen Hochgeschwindigkeitszug gemäß irgendeinem der vorherigen Ansprüche, wobei die erste Vorrichtung zum Belüften (34) ein zweites Organ zum Filtern (50) aufweist, welches im ersten Schacht (36) zwischen dem ersten Organ zum Filtern (44) und dem ersten Lüfter (42) angeordnet ist, wobei das besagte zweite Organ zum Filtern (50) durchlässig für Luft ist und imstande ist, feste Partikel mit Abmessungen, welche größer als ein zweiter Schwellwert sind, zurückzuhalten, wobei der besagte zweite Schwellwert kleiner als der erste Schwellwert ist.

6. Triebwagen für einen Hochgeschwindigkeitszug gemäß Anspruch 5, wobei das zweite Organ zum Filtern (50) ein Paneel aus Textilmaterial aufweist.

7. Triebwagen für einen Hochgeschwindigkeitszug gemäß irgendeinem der vorherigen Ansprüche, wobei die erste Vorrichtung zum Belüften (34) ferner zumindest eine Mündung zum Auslass von Luft (52, 54) aufweist, welche am Dach der Karosserie angeordnet und in Fluidkommunikation mit dem Technikraum ist.

8. Triebwagen für einen Hochgeschwindigkeitszug gemäß irgendeinem der vorherigen Ansprüche, wobei die Karosserie ferner zumindest eine zweite Vorrichtung zum Belüften (35) aufweist, welche verschieden von der ersten Vorrichtung zum Belüften (34) ist, wobei die besagte zweite Vorrichtung zum Belüften aufweist: einen zweiten Schacht (36) zur Zufuhr von Luft, welcher eine geschlossene Leitung zwischen einem Eingang und einem Ausgang, welcher am Technikraum offen ist, bildet, und einen zweiten Lüfter (42), welcher zwischen dem Eingang und dem Ausgang des besagten Schachts angeordnet ist, wobei der erste und der zweite Schacht in der Nähe von entgegengesetzten Enden der Karosserie (12) angeordnet sind.

## Claims

1. A power car (10) for a high-speed train, in particular for transporting passengers, said power car including a body (12) and at least one traction motor (16, 17) of said body,
said body comprising a roof (19) and a floor (20); the at least one traction motor being arranged under said floor,
the body further comprising an equipment room (24) defined between said roof and said floor,
said technical room including: electrical equipment (33) for controlling the at least one traction motor; and at least a first ventilation device (34) of said electrical equipment,
the power car being **characterized in that** the first ventilation device comprises: a first air intake sheath (36), forming a closed pipe between an inlet (38) and an outlet (40) open onto the equipment room; and a first fan (42) arranged between the inlet and the outlet of said first sheath, so as to create an overpressure in the technical room.

2. The power car for a high-speed train according to claim 1, wherein:
- the inlet (38) of the first sheath is arranged at the level of a first air inlet mouth (41) located on the roof (19) of the body, and
- the first ventilation device (34) comprises a first filtration member (44) arranged at the inlet of the first sheath (36), said first filtration member (44) being permeable to air and able to retain solid particles with dimensions larger than a first threshold.

3. The power car for a high-speed train according to claim 2, wherein the first filtration member (44) comprises deflector elements (46) of the louver type (46).

4. The power car for a high-speed train according to claim 3, wherein the deflector elements define air inlet channels (48) arranged along a direction (Y) perpendicular to a main movement direction (X) of the power car.

5. The power car for a high-speed train according to one of the preceding claims, wherein the first ventilation device (34) comprises a second filtration member (50), arranged in the first sheath (36) between the first filtration member (44) and the first fan (42), said second filtration member (50) being permeable to air and able to retain solid particles with dimensions larger than a second threshold, said second threshold being lower than the first threshold.

6. The power car for a high-speed train according to claim 5, wherein the second filtration member (50) comprises a panel made from a textile material.

7. The power car for a high-speed train according to one of the preceding claims, wherein the first ventilation device (34) further comprises at least one air outlet mouth (52, 54), located on the roof of the body and in fluid communication with the equipment room.

8. The power car for a high-speed train according to one of the preceding claims, wherein the body further comprises at least a second ventilation device (35) separate from the first ventilation device (34), said second ventilation device comprising: a second air intake sheath (36), forming a closed pipe between an inlet and an outlet open onto the equipment room; and a second fan (42) arranged between the inlet and the outlet of said sheath, the first and second sheaths being located close to opposite ends of the body (12).
